# EUROPEAN PATENT APPLICATION

(11) **EP 3 722 825 A1**
(43) Date of publication of application: **14.10.2020**
(21) Application number: 18884988.9
(22) Date of filing: 09.11.2018
(51) Int. Cl.: G01R 33/02, G01R 33/09, G01R 33/389, H01L 43/00

(54) **METHOD OF MANUFACTURING MAGNETIC SENSOR, AND MAGNETIC SENSOR ASSEMBLY**

(30) Priority: 05.12.2017 JP 2017233214
(71) Applicant: Showa Denko K.K., Tokyo 105-8518 (JP)
(72) Inventor: ENDO, Daizo, Ichihara-shi Chiba 290-0067 (JP)
(74) Representative: Strehl Schübel-Hopf & Partner
(86) International application number: PCT/JP2018/041623
(87) International publication number: WO 2019/111631

(57) **Abstract**

A method of manufacturing a magnetic sensor 1 includes: a hard magnetic material layer formation process forming a hard magnetic material layer 103 to be processed to a thin film magnet 20 on a disk-shaped nonmagnetic substrate 10; a soft magnetic material layer formation process forming a soft magnetic material layer 105 laminated on the hard magnetic material layer 103 on the substrate 10, the soft magnetic material layer 105 being processed into a sensitive element sensing a magnetic field; and a hard magnetic material layer magnetization process magnetizing the hard magnetic material layer 103 in the circumferential direction of the disk-shaped substrate 10.

## Description

### Technical Field

The present invention relates to a method of manufacturing a magnetic sensor and a magnetic sensor assembly.

### Background Art

As a conventional art described in a gazette, there exists a magnetic impedance effect element provided with a thin-film magnet composed of a hard magnetic substance film formed on a nonmagnetic substrate, an insulating layer covering the upside of the thin-film magnet, a magneto-sensitive part composed of one or plural rectangular soft magnetic substance films formed on the insulating layer and imparted with uniaxial anisotropy, and a conductor film for connecting the plural soft magnetic substance films of the magneto-sensitive part electrically. In a longitudinal direction of the magneto-sensitive part, both ends of the thin-film magnet are located outside both ends of the magneto-sensitive part. The insulating layer has openings above the respective ends of the thin-film magnet. On the insulating layer, a yoke section composed of a soft magnetic substance film is formed ranging from the ends of the thin-film magnet over to the vicinities of the ends of the magneto-sensitive part via the openings of the insulating layer (refer to Patent Document 1).

### Citation List

### Patent Literature

Patent Document 1: Japanese Patent Application Laid-Open Publication No. 2008-249406

### Summary of Invention

### Technical Problem

By the way, in the magnetic sensor using the magnetic impedance effect element, the bias magnetic field is applied to the magnetic impedance effect element to cause the impedance of the magnetic impedance effect element to linearly change with respect to the change of the external magnetic field. Examples of the method of generating the bias magnetic field include a method using the thin film magnet magnetized in in-plane direction. By use of the thin film magnet, it is unnecessary to provide a coil for generating the magnetic field.

The present invention provides a method of manufacturing a magnetic sensor capable of easily magnetizing thin film magnets of magnetic sensors manufactured by being arranged in a circumferential direction of a disk-shaped substrate.

### Solution to Problem

A method of manufacturing a magnetic sensor, to which the present invention is applied, includes: a hard magnetic material layer formation process forming a hard magnetic material layer to be processed into a thin film magnet on a disk-shaped nonmagnetic substrate; a soft magnetic material layer formation process forming a soft magnetic material layer laminated on the hard magnetic material layer on the substrate, the soft magnetic material layer being processed into a sensitive element sensing a magnetic field; and a hard magnetic material layer magnetization process magnetizing the hard magnetic material layer in a circumferential direction of the disk-shaped substrate.

In such a method of manufacturing a magnetic sensor, the hard magnetic material layer magnetization process performs the magnetization by rotating the substrate around a center thereof while moving a magnetizing member in a radial direction and the magnetizing member generates a magnetic field not less than a coercive force of the hard magnetic material layer in a direction along the circumferential direction of the substrate.

The magnetizing member is provided with a north pole and a south pole disposed in the circumferential direction, held in a state of being separated from the substrate with a predetermined distance, and provides the magnetic field to the hard magnetic material layer, the magnetic field being larger than the coercive force of the hard magnetic material layer.

With this, only small magnets are required to constitute the magnetizing member.

Moreover, in such a method of manufacturing a magnetic sensor, the soft magnetic material layer formation process forms the soft magnetic material layer by magnetron sputtering and provides uniaxial magnetic anisotropy in a direction intersecting the circumferential direction of the substrate by a magnetic field used in the magnetron sputtering.

With this, the uniaxial magnetic anisotropy can be provided at the same time of forming the soft magnetic material layer.

Then, in such a method of manufacturing a magnetic sensor, the magnetron sputtering in the soft magnetic material layer formation process is performed in a plane facing a surface of the substrate by use of a cathode in which magnets having an asymmetrical structure with respect to the center of the substrate rotate.

With this, an area of the soft magnetic material layer where the uniaxial magnetic anisotropy is provided can be enlarged.

Moreover, a control layer formation process forming a control layer between the substrate and the hard magnetic material layer can be included, the control layer controlling magnetic anisotropy of the hard magnetic material layer in an in-plane direction.

With this, it becomes easy to control an in-plane anisotropy of the hard magnetic material layer.

From another standpoint, a magnetic sensor assembly, to which the present invention is applied, includes: plural magnetic sensors, each of which includes: a thin film magnet constituted by a hard magnetic material layer and magnetized in an in-plane direction; and a sensitive element constituted by a soft magnetic material layer laminated on the hard magnetic material layer, the sensitive element sensing a magnetic field, wherein the thin film magnet in each of the plural magnetic sensors is magnetized in a circumferential direction of a disk-shaped substrate on which the plural magnetic sensors are formed.

In such a magnetic sensor assembly, the sensitive element includes a longitudinal direction and a short direction, the short direction being provided in a direction intersecting a direction in which the thin film magnet is magnetized.

Moreover, the sensitive element is constituted by plural soft magnetic material layers that are antiferromagnetically-coupled with a demagnetizing field suppressing layer composed of Ru or an Ru alloy interposed therebetween.

With this, the sensitivity of the sensitive element is improved.

### Advantageous Effects of Invention

According to the present invention, it is possible to provide a method of manufacturing a magnetic sensor capable of easily magnetizing thin film magnets of magnetic sensors manufactured by being arranged in a circumferential direction of a disk-shaped substrate.

### Brief Description of Drawings

FIGS. 1A and 1B show diagrams illustrating an example of a magnetic sensor to which the first exemplary embodiment is applied, where FIG. 1A is a plan view and FIG. 1B is a cross-sectional view along the IB-IB line in FIG. 1A;
FIGS. 2A and 2B show diagrams illustrating an example of a method of manufacturing the magnetic sensor, where FIGS. 2A to 2H show respective processes in the method of manufacturing the magnetic sensor;
FIG. 3 is a cross-sectional view illustrating an overview of a magnetron sputtering device;
FIGS. 4A and 4B show diagrams showing a configuration of a magnetic circuit in the magnetron sputtering device and schematic arrangement of magnetic sensors formed on a substrate (a magnetic sensor assembly), where FIG. 4A shows the configuration of the magnetic circuit viewed from a target side and FIG. 4B shows arrangement of the magnetic sensors formed on the substrate (the magnetic sensor assembly);
FIGS. 5A and 5B show diagrams showing a modified example of the magnetic circuit in the magnetron sputtering device and schematic arrangement of magnetic sensors formed on a substrate (a magnetic sensor assembly), where FIG. 5A shows the configuration of the modified example of the magnetic circuit viewed from a target side and FIG. 5B shows arrangement of the magnetic sensors formed on the substrate (the magnetic sensor assembly);
FIGS. 6A to 6C show diagrams illustrating an overview of a magnetizing device, where FIG. 6A is a plan view of the magnetizing device, FIG. 6B is a front elevational view of a magnetizing head in the magnetizing device and FIG. 6C is a side elevational view of the magnetizing head;
FIGS. 7A and 7B show diagrams illustrating an example of a magnetic sensor to which the second exemplary embodiment is applied, where FIG. 7A is a plan view and FIG. 7B is a cross-sectional view along the VIIB-VIIB line in FIG. 7A;
FIGS. 8A and 8B show diagrams illustrating an example of a magnetic sensor to which the third exemplary embodiment is applied, where FIG. 8A is a plan view and FIG. 8B is a cross-sectional view along the VIIIB-VIIIB line in FIG. 8A;
FIGS. 9A and 9B show diagrams illustrating an example of a magnetic sensor to which the fourth exemplary embodiment is applied, where FIG. 9A is a plan view and FIG. 9B is a cross-sectional view along the IXB-IXB line in FIG. 9A; and
FIGS. 10A and 10B show diagrams illustrating an example of a magnetic sensor to which the fifth exemplary embodiment is applied, where FIG. 10A is a plan view and FIG. 10B is a cross-sectional view along the XB-XB line in FIG. 10A.

### Description of Embodiments

The magnetic sensor to be described in the present specification uses a so-called magnetic impedance effect element.

Hereinafter, exemplary embodiments according to the present invention will be described in detail with reference to attached drawings.

### [First exemplary embodiment]

### (Configuration of magnetic sensor 1)

First, a configuration of a magnetic sensor 1 to which the first exemplary embodiment is applied will be described.

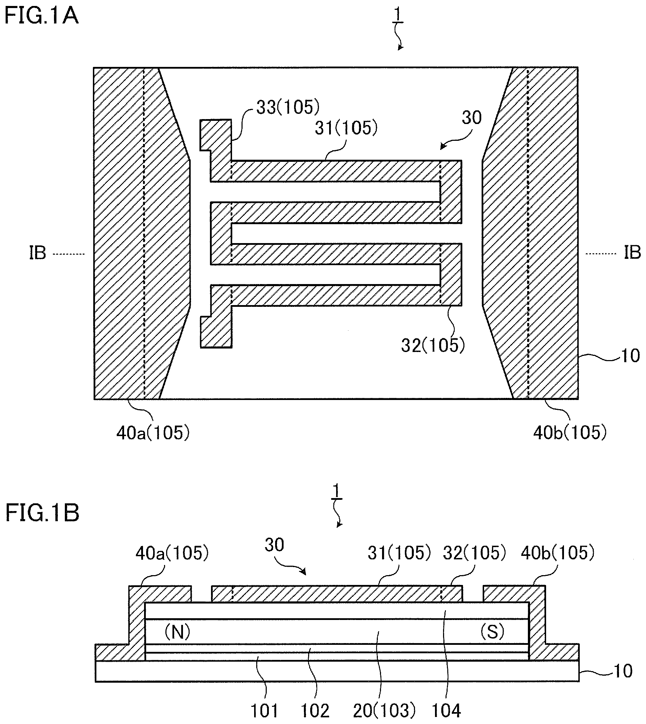

FIGS. 1A and 1B show diagrams illustrating an example of the magnetic sensor 1 to which the first exemplary embodiment is applied. FIG. 1A is a plan view and FIG. 1B is a cross-sectional view along the IB-IB line in FIG. 1A.

As shown in FIG. 1B, the magnetic sensor 1 to which the first exemplary embodiment is applied includes, as a basic configuration: a thin film magnet 20 constituted by a hard magnetic material (a hard magnetic material layer 103) on a nonmagnetic substrate 10; and a sensitive part 30 laminated to face the thin film magnet 20 and constituted by a soft magnetic material (the soft magnetic material layer 105) to sense a magnetic field. Note that details of a cross-sectional structure of the magnetic sensor 1 will be described later.

Here, the hard magnetic material has a large, so-called coercive force, the hard magnetic material being once magnetized by an external magnetic field, even upon removal of the external magnetic field, maintaining the magnetized state. On the other hand, the soft magnetic material has a small, so-called coercive force, the soft magnetic material being easily magnetized by an external magnetic field, but, upon removal of the external magnetic field, quickly returning to a state with no magnetization or a little magnetization.

Note that, in the present specification, an element constituting the magnetic sensor 1 is indicated by a two-digit number, and a layer processed into an element (the hard magnetic material layer 103 or the like) is indicated by a number of one hundreds. Then, for a figure indicating an element, a figure indicating a layer processed into the element is written in parentheses. For example, the case of the thin film magnet 20 is written as thin film magnet 20 (hard magnetic material layer 103). In the figure, the case is written as 20 (103). The same is true in other cases.

Description will be given of a planar structure of the magnetic sensor 1 by FIG. 1A. The magnetic sensor 1 has a quadrangular planar shape as an example. Here, description will be given of the sensitive part 30 and yokes 40a and 40b (when they are not distinguished, referred to as yokes 40) that can be seen from above the magnetic sensor 1. The sensitive part 30 and the yokes 40 are constituted by the soft magnetic material layer 105. The sensitive part 30 includes: plural reed-shaped sensitive elements 31 each having a longitudinal direction and a short direction in a planar shape thereof; connection parts 32 windingly performing serial connection of the adjacent sensitive elements 31; and terminal parts 33 to which electric wires for supplying the electrical current are connected. Here, four sensitive elements 31 are arranged so that the longitudinal directions thereof are in parallel with one another. The sensitive element 31 serves as a magneto-impedance effect element.

The sensitive part 31 has, for example, the length in the longitudinal direction of about 1mm, the width in the short direction of several tens of micrometers, and the thickness (the thickness of the soft magnetic material layer 105) of 0.5 µm to 5 µm. The intervals between the sensitive elements 31 are 50 µm to 100 µm.

The connection part 32 is provided between end portions of the adjacent sensitive elements 31 and windingly performs serial connection of the adjacent sensitive elements 31. In the magnetic sensor 1 shown in FIG. 1A, four sensitive elements 31 are disposed in parallel, and therefore there are three connection parts 32. The number of sensitive elements 31 is set in accordance with magnitude of the magnetic field to be sensed (measured) or an impedance of the sensitive part 30 to be described later. Consequently, if there are two sensitive parts 31, there is one connection part 32. Moreover, if there is one sensitive part 31, no connection part 32 is provided. Note that the width of the connection part 32 may be set in accordance with the electrical current to be applied to the sensitive part 30. For example, the width of the connection part 32 may be the same as that of the sensitive part 31.

The terminal parts 33 are provided to the (two) respective end portions of the sensitive parts 31, the end portions not being connected to the connection parts 32. The terminal part 33 includes a drawn-out part drawn out of the sensitive element 31 and a pad part connecting electric wires for supplying the electrical current. The drawn-out part is provided to dispose two pad parts in the short direction of the sensitive element 31. It may be possible to provide the pad part to be continuous with the sensitive element 31 without providing the drawn-out part. The pad part may have a size capable of connecting the electric wires. Note that, since there are four sensitive elements 31, the two terminal parts 33 are provided on the left side in FIG. 1A. In the case where the number of sensitive elements 31 is an odd number, two terminal parts 33 may be provided into right and left.

Then, the sensitive elements 31, the connection parts 32 and the terminal parts 33 of the sensitive part 30 are integrally constituted by a single layer of the soft magnetic material layer 105. The soft magnetic material layer 105 has conductivity, and therefore, it is possible to apply the electrical current from one terminal part 33 to the other terminal part 33.

Note that the above-described numerical values, such as the length and the width of the sensitive element 31 and the number of sensitive elements to be disposed in parallel, are merely an example; the numerical values may be changed in accordance with the value of the magnetic field to be sensed (measured) or the soft magnetic material to be used.

Further, the magnetic sensor 1 includes yokes 40 each of which is provided to face the end portions of the sensitive elements 31 in the longitudinal direction thereof. Here, there are provided two yokes 40a and 40b, each of which is provided with one end portion facing each of both end portions of the sensitive elements 31 in the longitudinal direction thereof. Note that, as shown in FIG. 1B, the other end portions (sides) of the yokes 40a and 40b are configured to face the north pole and the south pole of the thin film magnet 20, respectively. In FIG. 1B, the north pole and the south pole are referred to as (N) and (S), respectively. The yokes 40 guide lines of magnetic force from the thin film magnet 20 to the end portions of the sensitive elements 31 in the longitudinal direction thereof. Therefore, the yokes 40 are constituted by a soft magnetic material (the soft magnetic material layer 105) through which the lines of magnetic force are likely to pass. In other words, the sensitive part 30 and the yokes 40 are formed of a single layer of the soft magnetic material layer 105.

From above, the size of the magnetic sensor 1 is several millimeters square in the planar shape. Note that the planar shape of the magnetic sensor 1 may not be quadrangular and the size thereof may be other values.

Next, with reference to FIG. 1B, the cross-sectional structure of the magnetic sensor 1 will be described in detail. The magnetic sensor 1 is configured by disposing (laminating) an adhesive layer 101, a control layer 102, the hard magnetic material layer 103 (the thin film magnet 20), an insulating layer 104 and the soft magnetic material layer 105 (the sensitive part 30 and the yokes 40) in this order on a nonmagnetic substrate 10.

The substrate 10 is composed of a non-magnetic material; for example, an oxide substrate, such as glass or sapphire, or a semiconductor substrate, such as silicon, can be provided. Note that, in the case where the substrate 10 is a conductor, an electrical insulating layer may be provided on the substrate 10.

The adhesive layer 101 is a layer for improving adhesiveness of the control layer 102 to the substrate 10. As the adhesive layer 101, it is preferable to use an alloy containing Cr or Ni. Examples of the alloy containing Cr or Ni include CrTi, CrTa and NiTa. The thickness of the adhesive layer 101 is, for example, 5 nm 50 nm. Note that, if there is no problem in adhesiveness of the control layer 102 to the substrate 10, it is unnecessary to provide the adhesive layer 101. Note that, in the present specification, composition ratios of alloys containing Cr or Ni are not shown. The same applies hereinafter.

The control layer 102 controls the magnetic anisotropy of the thin film magnet 20 constituted by the hard magnetic material layer 103 to be likely to express in the in-plane direction of the film. As the control layer 102, it is preferable to use Cr, Mo or W, or an alloy containing thereof (hereinafter, referred to as an alloy containing Cr or the like to constitute the control layer 102). Examples of the alloy containing Cr or the like to constitute the control layer 102 include CrTi, CrMo, CrV and CrW. The thickness of the control layer 102 is, for example, 5 nm 100 nm.

It is preferable that the hard magnetic material layer 103 constituting the thin film magnet 20 uses an alloy that contains Co as a main component and also contains at least one of Cr and Pt (hereinafter, referred to as a Co alloy constituting the thin film magnet 20). Examples of the Co alloy constituting the thin film magnet 20 include CoCrPt, CoCrTa, CoNiCr and CoCrPtB. Note that Fe may be contained. The thickness of the hard magnetic material layer 103 is, for example, 50 nm to 500 nm.

The alloy containing Cr or the like to constitute the control layer 102 has a bcc (body-centered cubic) structure. Consequently, the hard magnetic material constituting the thin film magnet 20 (the hard magnetic material layer 103) preferably has an hcp (hexagonal close-packed) structure easily causing crystal growth on the control layer 102 composed of the alloy containing Cr or the like having the bcc structure. When crystal growth of the hard magnetic material layer 103 having the hcp structure is caused on the bcc structure, the c-axis of the hcp structure is likely to be oriented in a plane. Therefore, the thin film magnet 20 constituted by the hard magnetic material layer 103 is likely to have the magnetic anisotropy in the in-plane direction. Note that the hard magnetic material layer 103 is polycrystalline, and each crystal has the magnetic anisotropy in the in-plane direction. Consequently, the magnetic anisotropy is referred to as crystal magnetic anisotropy in some cases.

Note that, to promote the crystal growth of the alloy containing Cr or the like to constitute the control layer 102 and the Co alloy constituting the thin film magnet 20, the substrate 10 may be heated to 100°C to 600°C. By the heating, the crystal growth of the alloy containing Cr or the like constituting the control layer 102 is likely to be caused, and thereby crystalline orientation is likely to be provided so that the hard magnetic material layer 103 having the hcp structure includes an axis of easy magnetization in a plane. In other words, the magnetic anisotropy is likely to be imparted in a plane of the hard magnetic material layer 103.

The insulating layer 104 is constituted by nonmagnetic insulating material and electrically insulates the thin film magnet 20 and the sensitive part 30. Examples of the insulating material constituting the insulating layer 104 include oxide, such as SiO₂ or Al₂O₃, or nitride, such as Si₂N₄ or AlN. The thickness of the insulating layer 104 is, for example, 100 nm to 500 nm.

The sensitive element 31 in the sensitive part 30 is provided with uniaxial magnetic anisotropy in a direction crossing the longitudinal direction, for example, an intersecting short direction (the width direction). As the soft magnetic material constituting the sensitive element 31 (the soft magnetic material layer 105), it is preferable to use an amorphous alloy, which is an alloy containing Co as a main component doped with a high melting point metal, such as Nb, Ta or W (hereinafter, referred to as a Co alloy constituting the sensitive element 31). Examples of the Co alloy constituting the sensitive element 31 include CoNbZr, CoFeTa and CoWZr. The thickness of the soft magnetic material constituting the sensitive element 31 (the soft magnetic material layer 105) is, for example, 0.5 µm to 5 µm.

Note that the direction intersecting the longitudinal direction may have an angle exceeding 45° and not more than 90° with respect to the longitudinal direction.

The adhesive layer 101, the control layer 102, the hard magnetic material layer 103 (the thin film magnet 20) and the insulating layer 104 are processed to have a quadrangular planar shape (refer to FIG. 1A). Then, the line connecting the north pole and the south pole of the thin film magnet 20 faces the longitudinal direction of the sensitive element 31 in the sensitive part 30. Note that to face the longitudinal direction means that an angle formed by the line connecting the north pole and the south pole and the longitudinal direction is not less than 0° and less than 45°. Note that the smaller the angle formed by the line connecting the north pole and the south pole and the longitudinal direction, the better.

In the magnetic sensor 1, the lines of magnetic force coming out of the north pole of the thin film magnet 20 pass through the sensitive elements 31 via the yoke 40a and return to the south pole of the thin film magnet 20 via the yoke 40b. In other words, the thin film magnet 20 applies the magnetic field to the longitudinal direction of the sensitive elements 31. The magnetic field is referred to as a bias magnetic field.

Note that the north pole and the south pole of the thin film magnet 20 are collectively referred to as both magnetic poles, and when the north pole and the south pole are not distinguished, they are referred to as a magnetic pole. Here, in the figure, description will be given by assuming that the north pole is on the left side and the south pole is on the right side; however, the north pole and the south pole may be reversed.

Note that, as shown in FIG. 1A, the yoke 40 (the yokes 40a and 40b) is configured so that the shape thereof as viewed from the front surface side of the substrate 10 is narrowed as approaching the sensitive part 30. This is to gather the lines of magnetic force on the sensitive part 30. In other words, the magnetic field in the sensitive part 30 is strengthened to improve the sensitivity. Note that the width of the portion of the yoke 40 (the yokes 40a and 40b) facing the sensitive part 30 may not be narrowed.

Here, the interval between the yoke 40 (the yokes 40a and 40b) and the sensitive parts 30 may be, for example, 1 µm to 100 µm.

The magnetic sensor 1 is provided with uniaxial magnetic anisotropy in which, for example, an axis of easy magnetization faces the short direction (the width direction) intersecting the longitudinal direction of the sensitive elements 31. In the longitudinal direction of the sensitive elements 31, a magnetic field (a bias magnetic field) is applied by the thin film magnet 20. Then, in the state where the bias magnetic field is applied, a direct current or a high-frequency current is passed to the sensitive parts 30 from the two terminal parts 33 and a resistance value (impedance) between the terminal parts 33 is measured. The resistance value (impedance) between the terminal parts 33 is varied by a component of an external magnetic field in a direction along the longitudinal direction of the sensitive elements 31. Consequently, by the measurement of the resistance value (impedance) between the terminal parts 33, the external magnetic field or changes in the external magnetic field are measured. Note that, when the measurement is performed with the high-frequency current, variations in the impedance with respect to variations in the external magnetic field is increased by the skin effect.

Note that the bias magnetic field is provided to set the resistance value (impedance) between the terminal parts 33 in a state in which changes in the value are large with respect to the changes in the external magnetic field. In other words, application of the bias magnetic field to use the sharp changes in the impedance with respect to the external magnetic field makes it possible to grasp small changes in the external magnetic field.

### (Method of manufacturing magnetic sensor 1)

Next, a method of manufacturing the magnetic sensor 1 (a method of manufacturing a magnetic sensor) will be described. Plural magnetic sensors 1 are collectively manufactured on the substrate 10. Here, description will be given assuming that the substrate 10 is made of disk-shaped (circular) glass. As an example, the substrate 10 has the diameter of about 95 mm and a thickness of about 0.5 mm. Then, plural magnetic sensors 1 of several millimeters square are collectively manufactured on the substrate 10, and thereafter, divided (cut) into individual magnetic sensors 1. Hereinafter, description will be given while focusing on one magnetic sensor 1 shown in the center. Note that the portion for dividing the magnetic sensors 1 manufactured to be adjacent to each other is indicated by a long-dot-and-dash line.

In the manufacturing method to be described as follows, a lift-off method is used. Note that an etching method may also be used.

Note that, even in the cases of describing the substrate 10, various kinds of layers formed on one of the surfaces (hereinafter, referred to as a front surface) of the substrate 10 are included in some cases.

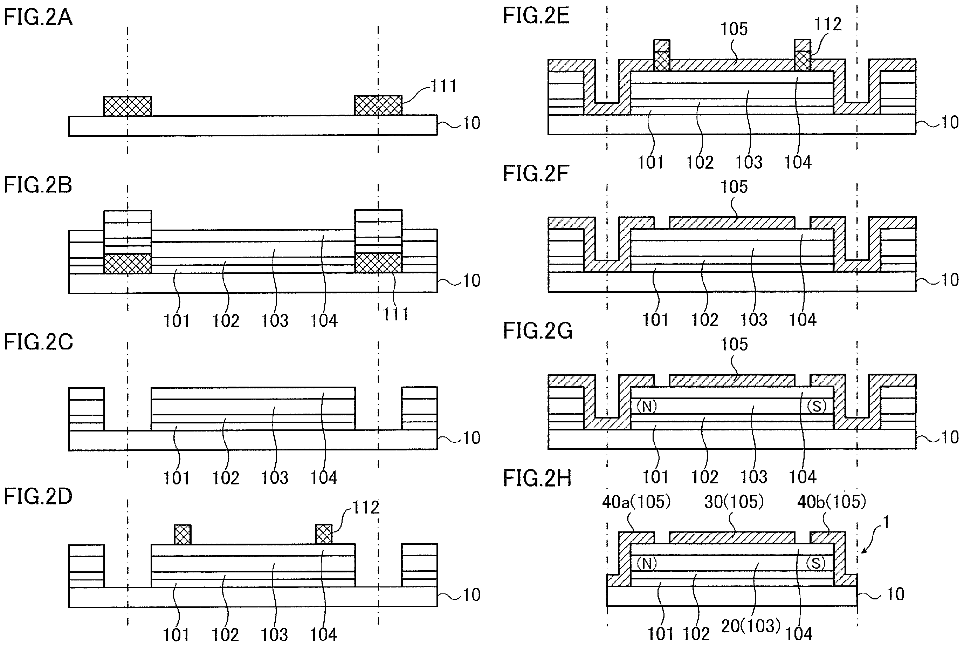

FIGS. 2A to 2H show diagrams illustrating an example of the method of manufacturing the magnetic sensor 1. FIGS. 2A to 2H show respective processes in the method of manufacturing the magnetic sensor 1. Note that FIGS. 2A to 2H show the representative processes, and other processes may be included. The processes proceed in the order of FIGS. 2A to 2H. FIGS. 2A to 2H correspond to the cross-sectional view along the IB-IB line in FIG. 1A shown in FIG. 1B.

As shown in FIG. 2A, after the substrate 10 is cleaned, on the front surface of the substrate 10, a resist pattern 111 including an opening for a portion where the thin film magnet 20 is formed is formed by a known photolithographic technique.

Next, as shown in FIG. 2B, on the front surface of the substrate 10 where the resist pattern 111 has been formed, the adhesive layer 101, the control layer 102, the hard magnetic material layer 103 and the insulating layer 104 are formed (accumulated) in order to form a laminated body. Note that the process of forming the laminated body of the adhesive layer 101, the control layer 102, the hard magnetic material layer 103 and the insulating layer 104 on the substrate 10 is referred to as a laminated body formation process. In addition, the process of forming the control layer 102 is referred to as a control layer formation process, and the process of forming the hard magnetic material layer 103 is referred to as a hard magnetic material layer formation process.

First, the adhesive layer 101 that is an alloy containing Cr or Ni, the control layer 102 that is an alloy containing Cr and the like, the hard magnetic material layer 103 that is a Co alloy constituting the thin film magnet 20 are continuously formed (accumulated) in order. The formation can be performed by a sputtering method or the like. The substrate 10 is moved so that the front surface of the substrate 10 faces plural targets formed of respective materials, and thereby the adhesive layer 101, the control layer 102 and the hard magnetic material layer 103 are laminated on the substrate 10 in order. As described above, in forming the control layer 102 and the hard magnetic material layer 103, it is preferable to heat the substrate 10 to, for example, 100°C to 600°C for accelerating the crystal growth.

Note that, in formation of the adhesive layer 101, the substrate 10 may be heated or may not be heated before the formation (accumulation). To remove the moisture and so forth absorbed onto the front surface of the substrate 10, the substrate 10 may be heated before the adhesive layer 101 is formed (accumulated).

Next, the insulating layer 104, which is oxide, such as SiO₂ or Al₂O₃, or nitride, such as Si₂N₄ or AlN is formed (accumulated). Formation of the insulating layer 104 can be performed by a plasma CVD method, a reactive sputtering method or the like.

Then, as shown in FIG. 2C, the resist pattern 111 is removed, and the adhesive layer 101, the control layer 102, the hard magnetic material layer 103 and the insulating layer 104 deposited on the resist pattern 111 are also removed (lift-off). Consequently, the side surfaces serving as the magnetic poles of the hard magnetic material layer 103 are exposed.

Next, as shown in FIG. 2D, a resist pattern 112, which has openings serving as the portions where the sensitive part 30 and the yokes 40 (the yoke 40a and the yoke 40b) are formed, is formed.

Then, as shown in FIG. 2E, the soft magnetic material layer 105 that is the Co alloy constituting the sensitive element 31 is formed (accumulated). As will be described later, the soft magnetic material layer 105 is formed by a magnetron sputtering device (the magnetron sputtering device 300 to be described later) using a magnetron sputtering method (sometimes referred to as magnetron sputter). In the magnetron sputtering method, a magnetic field is formed by using magnets and electrons generated by discharge are enclosed (concentrated) on a surface of a target. This increases collision probability of electrons and gases to accelerate ionization of gases, to thereby improve deposition rate of a film. As will be described later, settings are made so that the sensitive elements 31 of the magnetic sensor 1 are disposed in the magnetic field of the magnetron sputtering device 300 and the short direction (the width direction) of the sensitive elements 31 faces the direction of the magnetic field of the magnetron sputtering device 300. Therefore, during the formation (accumulation), in other words, at the same time of forming the soft magnetic material layer 105, the soft magnetic material layer 105 is provided with uniaxial magnetic anisotropy. The process of forming the soft magnetic material layer 105 is referred to as a soft magnetic material layer formation process.

Next, as shown in FIG. 2F, the resist pattern 112 is removed, and the soft magnetic material layer 105 on the resist pattern 112 is also removed (lift-off). Consequently, the sensitive part 30 and the yokes 40 (the yoke 40a and 40b) constituted by the soft magnetic material layer 105 are formed. In other words, the sensitive part 30 and the yokes 40 are formed by a single accumulation (formation) of the soft magnetic material layer 105. The process of forming the sensitive part 30 is referred to as a sensitive part formation process. Note that the sensitive part formation process may include the soft magnetic material layer formation process and/or a process of forming the yokes 40.

Thereafter, as shown in FIG. 2G, the hard magnetic material layer 103 is magnetized. Magnetization of the hard magnetic material layer 103 is performed by use of a magnetizing device (the magnetizing device 400 to be described later). In other words, in the magnetizing device 400, the substrate 10 is rotated while moving a magnetizing jig (the magnetizing head 420 to be described later) in the diameter direction, the magnetizing jig generating a magnetic field equal to or larger than the coercive force of the hard magnetic material layer 103 in the circumferential direction of the disk-shaped substrate 10. Consequently, the thin film magnet 20 is magnetized. The process of magnetizing the hard magnetic material layer 103 is referred to as a hard magnetic material layer magnetization process.

Thereafter, as shown in FIG. 2H, division (cutting) of the substrate 10 generates the individual magnetic sensors 1. The division (cutting) can be performed by a dicing method, a laser cutting method or the like. The process of dividing the magnetic sensor 1 is referred to as a dividing process.

Here, description was given with the cross-sectional view along the IB-IB line in FIG. 1A; however, in a direction orthogonal to the IB-IB line, the magnetic sensors 1 are divided as shown in FIG. 1A.

Note that, in the case where the control layer 102 is not provided, it becomes necessary to impart the magnetic anisotropy in a plane by causing the crystal growth by heating the hard magnetic material layer 103 to not less than 800°C after the hard magnetic material layer 103 was formed. However, if the control layer 102 is provided, since the crystal growth is accelerated by the control layer 102, the crystal growth caused by the high temperature, such as not less than 800°C, is not required. Consequently, in the case where the crystal growth by high temperature is used, the control layer 102 may not be provided.

Moreover, imparting of the uniaxial magnetic anisotropy to the soft magnetic material layer 105 was performed by using the magnetic field caused by the magnets used in the magnetron sputtering device 300. In the case that does not use the method, it becomes necessary to perform, for example, the heat treatment at 400°C in a rotating magnetic field of 3 kG (0.3T) (heat treatment in the rotating magnetic field) and the heat treatment at 400°C in a static magnetic field of 3 kG (0.3T) (heat treatment in the static magnetic field) subsequent thereto. In other words, by imparting the uniaxial magnetic anisotropy to the soft magnetic material layer 105 by the magnets used in the magnetron sputtering method, it is possible to omit the process of imparting the uniaxial magnetic anisotropy performed in the heat treatment in the rotating magnetic field and the heat treatment in the static magnetic field.

### (Magnetron sputtering device 300)

Here, description will be given of formation of the soft magnetic material layer 105 by use of the magnetron sputtering device 300 in FIG. 2E. First, the magnetron sputtering device 300 will be described.

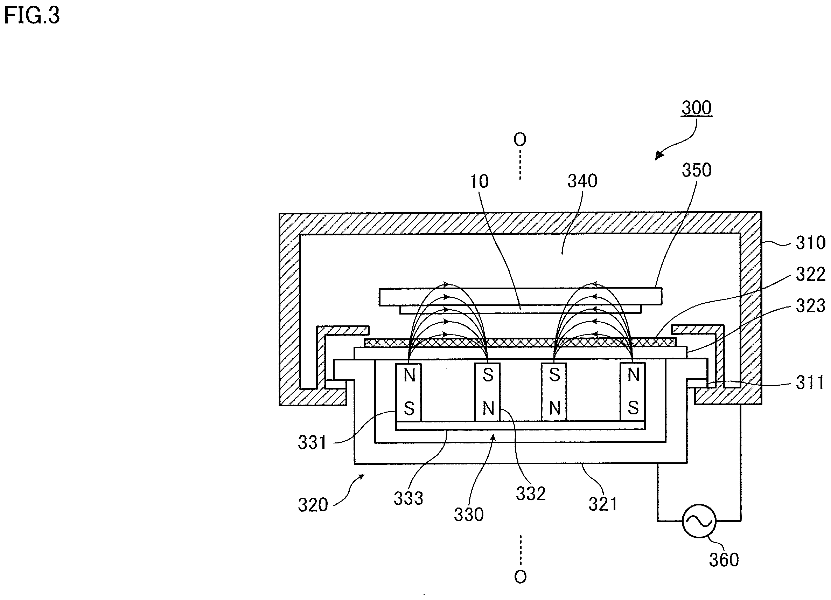

FIG. 3 is a cross-sectional view illustrating an overview of the magnetron sputtering device 300. The magnetron sputtering device 300 here is in a cylindrical shape with the O-O line in FIG. 3 as an axis.

The magnetron sputtering device 300 includes a partition wall 310 and a magnetron cathode 320. In addition, the magnetron sputtering device 300 is provided with a high-frequency power supply 360. The partition wall 310 and the magnetron cathode 320 constitute a chamber 340, which is sealed space, via an insulation member 311 made of polytetrafluoroethylene or the like. The chamber 340 includes a substrate holder 350 for holding the substrate 10.

Note that, though not shown in FIG. 3, the magnetron sputtering device 300 includes, other than the above, a vacuum pump reducing pressure in the chamber 340, a gas supply mechanism introducing gas used for sputtering, such as Ar, into the chamber 340, and a pressure adjustment mechanism keeping the pressure in the chamber 340 at a predetermined value. In addition, for cooling the magnetron cathode 320, a cooling mechanism supplying a cooling liquid to the magnetron cathode 320 may be provided. Then, a heating mechanism for heating the substrate 10, for example, an infrared lamp, or inversely, a cooling mechanism supplying a cooling liquid to the substrate holder 350 for cooling the substrate 10 may also be provided.

The partition wall 310 is grounded (GND). The substrate holder 350 is grounded (GND) via the partition wall 310 to function as an anode. In other words, a high-frequency power supply 360 is connected between the substrate holder 350 and the magnetron cathode 320 that have been grounded. Note that a DC power supply may be connected instead of the high-frequency power supply 360 to apply the direct current (DC) between the substrate holder 350 and the magnetron cathode 320.

The magnetron cathode 320 includes: a cathode housing 321; a target 322 constituted by a material of a thin film to be formed on the substrate 10; a backing plate 323 for holding the target 322; and a magnetic circuit 330 causing a magnetic field to pass through the backing plate 323 to be generated on the target 322 side.

The target 322 is composed of the above-described Co alloy (the soft magnetic material) constituting the above-described sensitive element 31.

The backing plate 323 is composed of oxygen-free copper or the like having high conductivity. The target 322 is fastened to the surface of the backing plate 323 by a conductive adhesive agent or the like.

The cathode housing 321 is constituted by a stainless steel or the like. The backing plate 323 to which the target 322 is attached is fastened to the cathode housing 321, and the magnetic circuit 330 is provided to the side of the backing plate 323 on which the target 322 has not been provided.

The size (diameter) of the target 322 is set so that a film can be formed (deposited) within a predetermined region (scope) of the substrate 10. Here, the diameter of the target 322 is set larger than the diameter of the substrate 10 (about 95 mm).

The magnetic circuit 330 includes: a magnet 331 on the backing plate 323 side of which a north pole is exposed; a magnet 332 on the backing plate 323 side of which a south pole is exposed; and a yoke 333 provided on a side of the magnets 331 and 332 opposite to the backing plate 323 side, the yoke 333 guiding the lines of the magnetic field from the north pole of the magnet 332 to the south pole of the magnet 331. In general, a permanent magnet is used for the magnets 331 and 332.

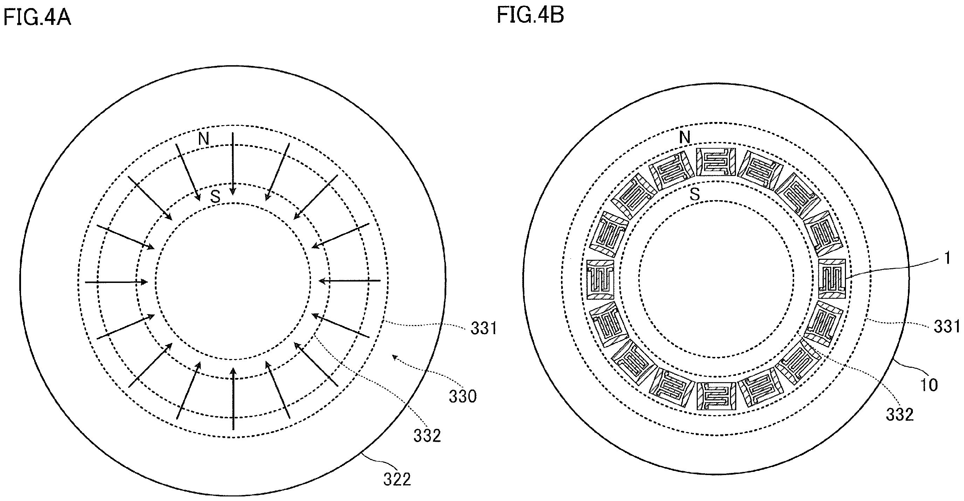

Here, as shown in FIGS. 4A and 4B to be described later, the magnets 331 and 332 are concentrically provided so that the magnet 331 on the backing plate 323 side of which the north pole is exposed is positioned at the outer side and the magnet 332 on the backing plate 323 side of which the south pole is exposed is positioned at the inner side.

Then, magnetic field lines (indicated by arrows) heading from the north pole of the magnet 331 to the south pole of the magnet 332 penetrate through the backing plate 323 and the target 322 to be generated in the chamber 340. A part of the lines of the magnetic field reaches the substrate 10 held by the substrate holder 350 and passes through the substrate 10 in the direction parallel to the front surface. That is, in a portion of the substrate 10 where the magnetic field lines passing through, a magnetic field in the direction parallel to the front surface is generated.

In other words, due to the magnetic field generated in the substrate 10 in the direction parallel to the front surface thereof, the uniaxial magnetic anisotropy is provided to the soft magnetic material layer 105 as the soft magnetic material layer 105 is formed (accumulated) on the substrate 10.

Note that, in the magnetron sputtering device 300, electrons generated by discharge caused by the high-frequency power supply 360 are concentrated (confined) to the vicinity of the target 322 by the magnetic field lines on the front surface of the target 322. This increases collision probability of electrons and gases to accelerate ionization of gases, to thereby improve deposition rate of the film. Note that the front surface of the target 322 where the electrons are concentrated by the magnetic field lines becomes a scope to be eroded by impacts of ions of the ionized gases.

The substrate holder 350 is composed of Al, Cu, an alloy thereof, or the like. The substrate holder 350 holds the substrate 10 by a mechanism (not shown) holding the substrate 10.

As described above, the magnetron sputtering device 300 has a cylindrical shape. The target 322 is also in a disk shape (in a circular shape). The substrate 10 is also in a disk shape (in a circular shape) and is held by the substrate holder 350 to face the target 322 (refer to FIGS. 4A and 4B to be described later).

As described above, the magnetron sputtering device 300 shown in FIG. 3 is a so-called sheet-fed type sputtering device forming (accumulating) a film on each of the substrates 10.

In addition, the magnetron sputtering device 300 shown in FIG. 3 was configured so that the surface of the substrate 10 (the surface of the target 322) was horizontally (in left and right directions in the page of FIG. 3) disposed; however, the device may be configured so that the surface of the substrate 10 is vertically (in up and down directions in the page of FIG. 3) disposed.

FIGS. 4A and 4B show diagrams showing a configuration of a magnetic circuit 330 in the magnetron sputtering device 300 and schematic arrangement of magnetic sensors 1 formed on the substrate 10 (a magnetic sensor assembly). FIG. 4A shows the configuration of the magnetic circuit 330 viewed from the target 322 side and FIG. 4B shows arrangement of the magnetic sensors 1 formed on the substrate 10 (the magnetic sensor assembly).

As shown in FIG. 4A, the target 322 is in a disk shape. The magnetic circuit 330 viewed through the target 322 is concentrically provided with the north pole of the magnet 331 and the south pole of the magnet 332. Then, thought the target 322, the magnetic field lines (arrows) heading from the north pole of the magnet 331 toward the south pole of the magnet 332 are formed.

Then, as shown in FIG. 4B, the substrate 10 is in a disk shape provided to face the target 322. Note that, in FIG. 4B, positions of the magnets 331 and 332 of the facing magnetic circuit 330 are aligned. The magnetic sensors 1 are arranged (disposed) so that, in the portion of the substrate 10 where the lines of the magnetic field pass through (the magnetic field), the short direction (the width direction) of the sensitive elements 31 formed by processing the soft magnetic material layer 105 faces the direction in which the lines of the magnetic field pass through. For example, the magnetic sensors 1 are arranged (disposed) so that, between the circle formed by the north pole of the magnet 331 and the circle formed by the south pole of the magnet 332, the short direction (the width direction) of the sensitive elements 31 is aligned with the diameter direction of the circles.

Here, one magnetic sensor 1 is shown between the circle formed by the north pole of the magnet 331 and the circle formed by the south pole of the magnet 332 in the magnetic circuit 330. This is to schematically describe a relationship between the sensitive elements 31 of the magnetic sensor 1 and the magnetic field generated by the north pole of the magnet 331 and the south pole of the magnet 332. The magnetic sensor 1 is disposed so that the short direction of the sensitive elements 31 is in line with the direction of the magnetic field. Then, plural magnetic sensors 1 are disposed along the circumferential direction.

Note that, as described above, the planar shape of the magnetic sensor 1 is several millimeters square. Consequently, in actuality, the plural magnetic sensors 1 are disposed in the magnetic field formed by the north pole of the magnet 331 and the south pole of the magnet 332. Moreover, this holds true in the circumferential direction.

Note that the central portion or the outer circumferential portion of the substrate 10 is less affected by the magnetic field caused by the magnetic circuit 330. In other words, the uniaxial magnetic anisotropy is less likely to be provided to the soft magnetic material layer 105 by the magnetic field caused by the magnetic circuit 330. The region on the substrate 10 where the magnetic sensors 1 are to be provided may be a region where predetermined uniaxial magnetic anisotropy is provided. Note that the magnetic field is strong between the north pole of the magnet 331 and the south pole of the magnet 332. Consequently, it is preferable to dispose the magnetic sensor 1 between the north pole of the magnet 331 and the south pole of the magnet 332, and it is preferable not to dispose the magnetic sensors 1 at the center portion or the outer circumferential portion of the substrate 10 where the uniaxial magnetic anisotropy is hard to be provided. Note that, if the predetermined uniaxial magnetic anisotropy is provided, the region where the magnetic sensors 1 are to be provided may not be the region between the north pole of the magnet 331 and the south pole of the magnet 332. Moreover, the uniaxial magnetic anisotropy may be provided to the magnetic sensors 1 disposed at the center portion or the outer circumferential portion of the substrate 10 by the heat treatment in the rotating magnetic field, the heat treatment in the static magnetic field, or the like.

### (Modified example of magnetic circuit 330 in magnetron sputtering device 300)

Next, a modified example of the magnetic circuit 330 in the magnetron sputtering device 300 will be described.

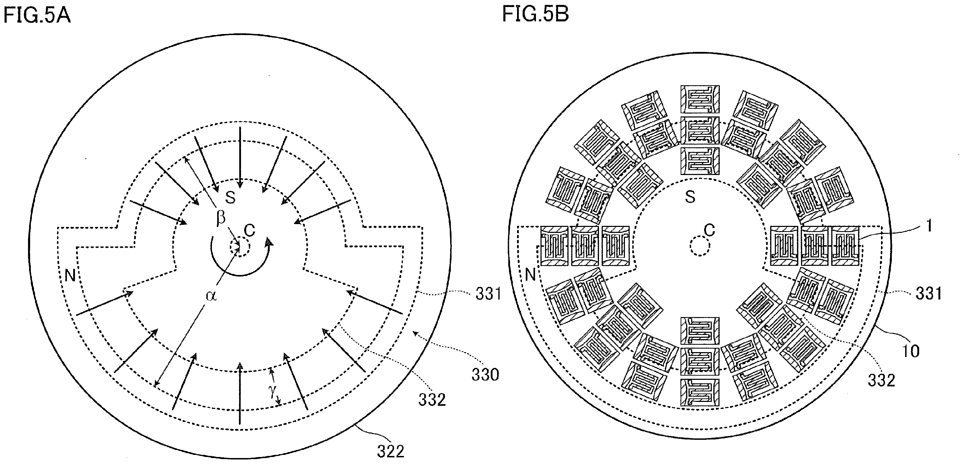

FIGS. 5A and 5B show diagrams showing a configuration of the modified example of the magnetic circuit 330 in the magnetron sputtering device 300 and schematic arrangement of magnetic sensors 1 formed on the substrate 10 (the magnetic sensor assembly). FIG. 5A shows the configuration of the modified example of the magnetic circuit 330 viewed from the target 322 side and FIG. 5B shows arrangement of the magnetic sensors 1 formed on the substrate 10 (the magnetic sensor assembly).

As shown in FIG. 5A, in the magnetic circuit 330 of the modified example, similar to the magnetic circuit 330 shown in FIGS. 4A and 4B, the target 322 is in a disk shape and the magnet 331 is provided to enclose the magnet 332. However, the magnet 331 is configured to include a portion with a distance α from the center C of the target 322 to an end thereof and a portion with a distance β that is shorter than the distance α (α>β). Then, a distance y between the magnet 331 and the magnet 332 is provided roughly the same. In other words, the magnet 331 and the magnet 332 of the magnetic circuit 330 are asymmetrically configured with respect to the center C.

Note that the other configurations of the magnetron sputtering device 300 including the magnetic circuit 330 of the modified example are the same as that of the magnetron sputtering device 300 shown in FIG. 3. Therefore, descriptions of the similar portions will be omitted.

The magnet 331 and the magnet 332 are configured to rotate around the center C of the target 322 as a rotation axis while keeping this states. Note that the magnetic circuit 330 provided with the magnets 331 and 332 rotates, whereas the target 322 (the backing plate 323 (refer to FIG. 3) does not rotate. In other words, on a back surface of the target 322 (the backing plate 323), the magnetic circuit 330 rotates within a virtual plane (a plane including an end portion of the north pole of the magnet 331 and an end portion of the south pole of the magnet 332) in parallel with the surface of the target 322 (the backing plate 323). Here, since the target 322 and the substrate 10 are disposed in parallel with each other, the magnetic circuit 330 rotates in-plane in parallel with the surface of the substrate 10. Note that the magnetic circuit 330 is not necessarily needed to rotate in-plane in parallel with the substrate 10; the magnetic circuit 330 may rotate in-plane facing the surface of the substrate 10.

With this, on the target 322, a magnetic field caused in the portions between the distance α and the distance α-γ from the center C and a magnetic field caused in the portions between the distance β and the distance β-γ from the center C are alternately generated. This enlarges the region (area) where the electrons are added, as compared to the case shown in FIG. 4A. Consequently, the scope in which the target 322 is to be eroded by impacts of ions is expanded, and thereby the efficiency of use of the target 322 is increased.

Moreover, since an area on which the magnetic field is to be formed is enlarged, the area on which the uniaxial magnetic anisotropy is provided to the soft magnetic material layer 105 is enlarged also on the substrate 10. That is to say, the region capable of forming the magnetic sensors 1 is enlarged. Accordingly, as shown in FIG. 5B, the magnetic sensors 1 are arranged so that, in the portion of the magnetic circuit 330 where the magnetic field lines generated by the magnets 331 and 332 pass through, the short direction (the width direction) of the sensitive elements 31 formed of the soft magnetic material layer 105 faces the direction in which the magnetic field lines pass through (the direction of the magnetic field). For example, the magnetic sensors 1 are disposed inside the magnetic field formed by the magnets 331 and 332 in the magnetic circuit 330, which is between a circle assuming the maximum distance from the center C to the north pole of the magnet 331 as a radius and a circle assuming the minimum distance from the center C to the south pole of the magnet 332 as a radius. In this manner, as compared to the case shown in FIG. 4B, the number of magnetic sensors 1 that can be manufactured on the substrate 10 is increased.

Note that, in FIG. 5B, positions of the magnets 331 and 332 of the facing magnetic circuit 330 are aligned.

Here, three magnetic sensors 1 are shown in the diameter direction between the circle assuming the maximum distance from the center C to the north pole of the magnet 331 as a radius and the circle assuming the minimum distance from the center C to the south pole of the magnet 332 as a radius. This is to schematically describe a relationship between the sensitive elements 31 of the magnetic sensor 1 and the magnetic field generated by the north pole of the magnet 331 and the south pole of the magnet 332. The magnetic sensors 1 are disposed along the circumference so that the short direction of the sensitive elements 31 in the sensitive part 30 is in line with the direction of the magnetic field.

Note that, as described above, the planar shape of the magnetic sensor 1 is several millimeters square. Consequently, the plural magnetic sensors 1 are disposed in the direction (the diameter direction) of the magnetic field formed by the north pole of the magnet 331 and the south pole of the magnet 332. Moreover, this holds true in the circumferential direction.

Note that the arrangement and shape of the magnets 331 and 332 constituting the magnetic circuit 330 may be the arrangement and shape other than those shown in FIGS. 5A and 5B. The arrangement and shape of the magnets 331 and 332 may be set to enlarge the area in which the uniaxial magnetic anisotropy of the soft magnetic material layer 105 formed on the substrate 10 can be obtained.

### (Magnetizing device 400)

Next, description will be given of magnetization of the hard magnetic material layer 103 by using the magnetizing device 400 in FIG. 2G. First, the magnetizing device 400 will be described.

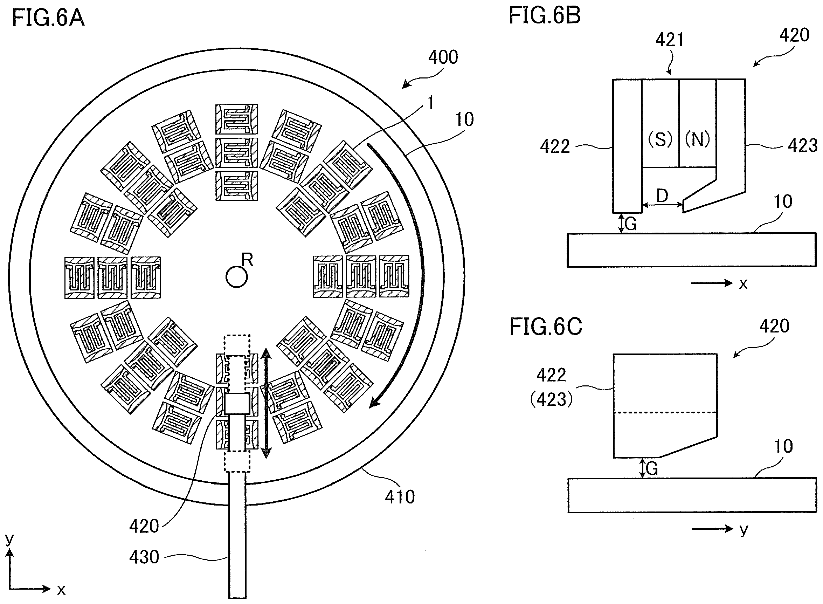

FIGS. 6A and 6B show diagrams illustrating an overview of the magnetizing device 400. FIG. 6A is a plan view of the magnetizing device 400, FIG. 6B is a front elevational view of the magnetizing head 420 in the magnetizing device 400 and FIG. 6C is a side elevational view of the magnetizing head 420. Note that, in FIG. 6A, the magnetic sensors 1 (the magnetic sensor assembly) shown in FIG. 5B are also shown together.

As shown in FIG. 6A, the magnetizing device 400 includes: a stage 410 rotating while holding the substrate 10 on which the magnetic sensors 1 have been manufactured; the magnetizing head 420 magnetizing the hard magnetic material layer 103; and a holder part 430 holding the magnetizing head 430. Note that, as shown in FIG. 6A, the x direction and the y direction are defined in in-plane of the stage 410. Here, the magnetizing head 420 is an example of a magnetizing member.

The stage 410 is composed of a nonmagnetic material, for example, a metallic material, such as Al, Cu, an alloy thereof or the like, or a plastic material. Then, the stage 410 is rotated in the direction indicated by an arrow (clockwise in the figure) around the center R by a not-shown rotation mechanism. The rotation speed is, for example, 10 rpm to several thousand rpm. The rotation speed may be set so that the hard magnetic material layer 103 can be magnetized as determined in advance.

As shown in the front elevational view in FIG. 6B, the magnetizing head 420 includes a magnet 421, a yoke 422 that is in contact with the south pole of the magnet 421 and a yoke 423 that is in contact with the north pole of the magnet 421. Note that the south pole and the north pole of the magnet 421 are provided to face each other in the x direction. Then, a tip end portion of the yoke 423 is bent toward the yoke 422 side to have a distance D at the tip end portion. The distance D between the tip end portion of the yoke 422 and the tip end portion of the yoke 423 is set, for example, in the neighborhood of 1mm. The distance (the gap) G between the tip end portions of the yokes 422 and 423 and the substrate 10 (the magnetic sensor 1) is set at, for example, about 0.3 mm. Then, as the magnet 421, a strong magnet, such as NdFeB, that generates a magnetic field between the tip end portion of the yoke 422 and the tip end portion of the yoke 423 with a coercive force equal to or larger than that of the hard magnetic material layer 103 is selected.

In the plan view of the magnetizing device 400 shown in FIG. 6A, the magnetizing head 420 has the lengths of 10 mm in the x direction and 9 mm in the y direction. Then, as shown in FIGS. 6B and 6C, the yokes 422 and 423 of the magnetizing head 420 are subjected to tapering processing on the substrate 10 side thereof to concentrate the lines of magnetic force from the magnet 421, to thereby strengthen the magnetic field.

Note that the magnetizing head 420 may have other dimensions and may be processed into other forms.

Then, the magnetizing head 420 is held by the holder part 430 with the distance G from the substrate 10. The holder part 430 is moved in the y direction and the -y direction on the semicircle of the disk-shaped substrate 10 by a not-shown moving mechanism. Here, the magnetizing head 420 is moved in the y direction in the state of approaching the substrate 10 with the distance G and is moved in the -y direction in the state of being separated from the substrate 10 with a distance larger than the distance G.

As described above, the magnetizing device 400 places the substrate 10 on which the magnetic sensors 1 are manufactured on the stage 410 and rotates thereof, and moves the magnetizing head 420 in the radial direction of the substrate 10, to thereby trace the front surface of the substrate 10. On this occasion, the tip end portions of the yokes 422 and 423 of the magnetizing head 420 generate a magnetic field having a coercive force equal to or larger than that of the hard magnetic material layer 103 in the circumferential direction (the x direction). Accordingly, the hard magnetic material layer 103 is magnetized in the circumferential direction of the substrate 10. Consequently, the hard magnetic material layer 103 is magnetized to be the thin film magnet 20.

The hard magnetic material layer magnetization process (FIG. 2G) using the above-described magnetizing device 400 may be performed immediately after the hard magnetic material layer formation process (FIG. 2B). However, in the case where there is a possibility that the magnetic field is applied to the hard magnetic material layer 103 after being magnetized, such as the case of forming the soft magnetic material layer 105 by using the magnetron sputtering device 300, it is preferable to perform the hard magnetic material layer magnetization process after the process with the possibility of application of the magnetic field.

As described above, in the case where the soft magnetic material layer 105 is formed by use of the disk-shaped magnetron cathode 320, the short direction of the sensitive elements 31 of the sensitive part 30 is in line with the diameter direction of the substrate 10. In this case, the thin film magnet 20 is disposed in line with the longitudinal direction of the sensitive elements 31. In other words, the directions of the both magnetic poles (the north pole and the south pole) of the thin film magnet 20 are in line with the circumferential direction of the substrate 10. Consequently, in the case where the soft magnetic material layer 105 is formed by the magnetron sputtering device 300 using the disk-shaped magnetron cathode 320, use of the above-described magnetizing device 400 makes it possible to magnetize the hard magnetic material layer 103 with ease.

Even in the case where the soft magnetic material layer 105 is formed without using the magnetron sputtering device 300, when the thin film magnet 20 is configured in the circumferential direction of the disk-shaped substrate 10, the above-described magnetizing device 400 can be applied.

Note that, in the case where the magnetic sensors 1 are arranged in a matrix (in a grid pattern) on the substrate 10 to magnetize the whole substrate 10, it becomes necessary to generate a magnetic field to be used in magnetization in space capable of containing the whole substrate 10. The magnetizing device in this case is a large device using a strong, large-sized magnet. However, in the above-described magnetizing device 400, it is sufficient that the magnetic field equal to or larger than the coercive force is generated between the yokes 422 and 423 (for example, about 1 mm) of the magnetizing head 420. Accordingly, the small magnet 421 may be used, and thereby the magnetizing device 400 can be downsized.

Note that, in FIGS. 4B and 5B, the state in which the individual magnetic sensors 1 have not been cut from the substrate 10 (the magnetic sensor assembly) is shown. Other than the form of being individually divided, the magnetic sensors 1 can also be shipped in such a state. In this case, the substrate 10 is divided into the individual magnetic sensors 1 at the shipment's destination. Moreover, the magnetic sensor assembly can be shipped in a state in which the substrate 10 is bonded to an adhesive sheet and cut into the respective magnetic sensors 1 by a cutting means, such as a laser, and thereafter, the adhesive sheet is enlarged to make it easy to take out the magnetic sensors 1. In this case, the individual magnetic sensors 1 are taken out of the adhesive sheet at the shipment's destination. Here, these are referred to as magnetic sensor assemblies. Note that the magnetic sensor assembly may be a part of the substrate 10.

In any magnetic sensor assembly, the individual magnetic sensors 1 are disposed in a state reflecting the disposition of the magnets 331 and 332 of the magnetic circuit 330 in the magnetron cathode 320 of the magnetron sputtering device 300 forming the soft magnetic material layer 105. Then, the directions of the both magnetic poles of the thin film magnet 20 are in line with a direction intersecting the direction of the magnets 331 and 332 of the magnetic circuit 330 in the magnetron cathode 320 of the magnetron sputtering device 300. In other words, the thin film magnet 20 of the magnetic sensor 1 is also disposed in a state reflecting the disposition of the magnets 331 and 332 of the magnetic circuit 330 in the magnetron cathode 320 of the magnetron sputtering device 300 forming the soft magnetic material layer 105.

### [Second exemplary embodiment]

In a magnetic sensor 1 to which the first exemplary embodiment is applied, the sensitive part 30 was constituted by a single layer of the soft magnetic material layer 105. In a magnetic sensor 2 to which the second exemplary embodiment is applied, the sensitive part 30 is constituted by two soft magnetic material layers provided with a demagnetizing field suppressing layer interposed therebetween.

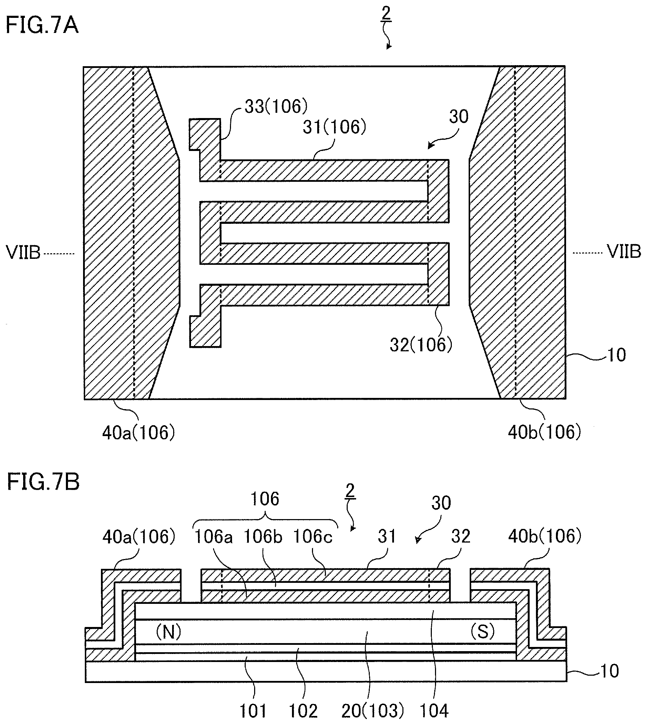

FIGS. 7A and 7B show diagrams illustrating an example of the magnetic sensor 2 to which the second exemplary embodiment is applied. FIG. 7A is a plan view and FIG. 7B is a cross-sectional view along the VIIB-VIIB line in FIG. 7A. Hereinafter, portions different from those of the magnetic sensor 1 will be mainly described, and similar portions will be assigned with same reference signs to thereby omit descriptions thereof.

As shown in FIG. 7B, in the magnetic sensor 2, a magnetic material layer 106 includes a lower soft magnetic material layer 106a on a lower layer (the substrate 10) side, a demagnetizing field suppressing layer 106b and an upper soft magnetic material layer 106c on an upper layer (opposite to the substrate 10) side. In other words, the lower soft magnetic material layer 106a and the upper soft magnetic material layer 106c are provided with the demagnetizing field suppressing layer 106b interposed therebetween.

For the lower soft magnetic material layer 106a and the upper soft magnetic material layer 106c, similar to the soft magnetic material layer 105 in the magnetic sensor 1, the Co alloy constituting the sensitive part 31 can be used. For the demagnetizing field suppressing layer 106b, Ru or an Ru alloy can be used.

Here, the thickness of the demagnetizing field suppressing layer 106b made of Ru or the Ru alloy ranging from 0.4 nm to 1.0nm or from 1.6 nm to 2.6 nm provides an AntiFerromagnetically-Coupled (AFC) structure to the lower soft magnetic material layer 106a and the upper soft magnetic material layer 106c. In other words, the demagnetizing field is suppressed, and thereby sensitivity of the sensitive element 31 is improved.

Note that the yokes 40 (the yokes 40a and 40b) are also constituted by the magnetic material layer 106, and it is sufficient that the yokes 40 can guide the lines of magnetic force from the thin film magnet 20 to pass through the sensitive elements 31. Note that the yokes 40 (the yokes 40a and 40b) may be constituted by a single soft magnetic material layer.

For the magnetic sensor 2, in the soft magnetic material layer formation process shown in FIG. 2E, the magnetic material layer 106 may be formed (accumulated) instead of forming (accumulating) the soft magnetic material layer 105. In other words, the lower soft magnetic material layer 106a, the demagnetizing field suppressing layer 106b and the upper soft magnetic material layer 106c may be continuously formed (accumulated) in this order in place of the soft magnetic material layer 105. The formation (accumulation) can be performed by the sputtering method. Then, the lower soft magnetic material layer 106a and the upper soft magnetic material layer 106c may be formed by the magnetron sputtering device 300. The other processes may be the same as those in the magnetic sensor 1. In other words, magnetization of the thin film magnet 20 in the magnetic sensor 2 can be performed by applying the magnetizing device 400 described in the first exemplary embodiment.

Note that, in the case where the yokes 40 (the yoke 40a and 40b) are constituted by the single soft magnetic material layer, formation of the magnetic material layer 106 of the sensitive part 30 and formation of the yokes 40 (the yokes 40a and 40b) may be performed in different processes.

### [Third exemplary embodiment]

In the magnetic sensor 1 to which the first exemplary embodiment was applied (refer to FIGS. 1A and 1B), the connection part 32 and the terminal part 33 of the sensitive part 30 were constituted by the soft magnetic material layer 105, which was same as the sensitive element 31. In a magnetic sensor 2 to which the second exemplary embodiment is applied, the connection part 32 and the terminal part 33 are constituted by a nonmagnetic conductor (a conductor layer).

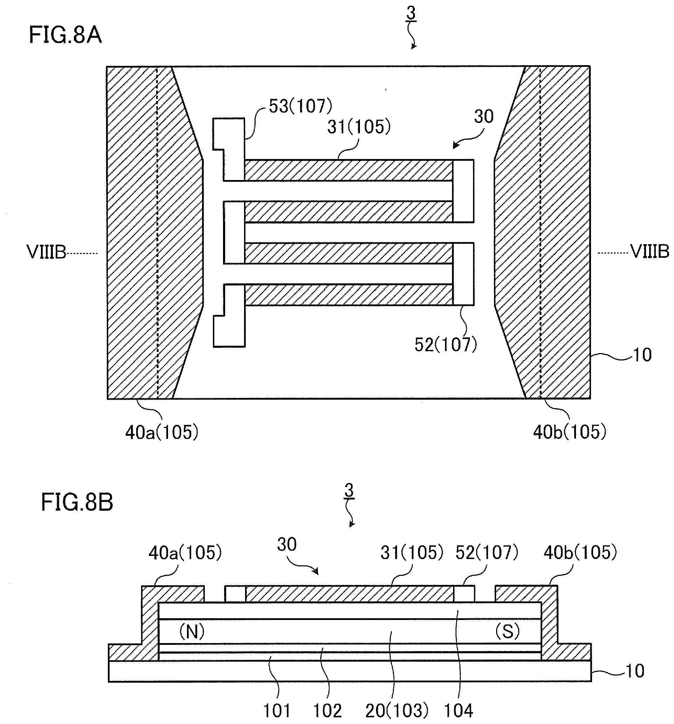

FIGS. 8A and 8B show diagrams illustrating an example of the magnetic sensor 3 to which the third exemplary embodiment is applied. FIG. 8A is a plan view and FIG. 8B is a cross-sectional view along the VIIIB-VIIIB line in FIG. 8A. Hereinafter, portions different from those of the magnetic sensor 1 will be mainly described, and similar portions will be assigned with same reference signs to thereby omit descriptions thereof.

As shown in FIG. 8A, the sensitive part 30 of the magnetic sensor 3 includes, in place of the connection parts 32, connection conductive parts 52 each constituted by the nonmagnetic conductor layer 107 and, in place of the terminal parts 33, terminal conductive parts 53 each similarly constituted by the nonmagnetic conductor layer 107.

The nonmagnetic conductor layer 107 constituting the connection conductive part 52 and the terminal conductive part 53 may be made of a material with excellent conductivity, and, for example, Cu, Au, Al, an alloy thereof or the like can be used.

In the magnetic sensor 1 shown in FIGS. 1A and 1B, since the connection part 32 and the terminal part 33 are constituted by the soft magnetic material layer 105, the magneto-impedance effect is generated also in the connection part 32 and the terminal part 33. However, the magnetic sensor 3 uses the connection conductive part 52 and the terminal conductive part 53 constituted by the nonmagnetic conductor layer 107; therefore, the magnetic field by the magneto-impedance effect caused only by the sensitive element 31 is detected. Accordingly, only the magneto-impedance effect in the direction of the magnetic field to be detected is extracted, and thereby the detection sensitivity or the detection accuracy is improved.

In addition, by using the terminal conductive part 53, it becomes easy to connect the electric wire for supplying the electrical current to the sensitive part 30.

Formation (accumulation) of the nonmagnetic conductor layer 107 constituting the connection conductive part 52 and the terminal conductive part 53 can be performed by, for example, the sputtering method, the vacuum deposition method or the like using a metal mask. In other words, after the sensitive part formation process in FIG. 2F, the conductor layer 107 may be formed (accumulated) through a metal mask in which regions of the connection conductive part 52 and the terminal conductive part 53 are opened.

Alternatively, the connection conductive part 52 and the terminal conductive part 53 may be formed by a lift-off method using a photoresist. In other words, subsequent to the sensitive part formation process in FIG. 2F, it may be possible that a resist pattern in which the regions for forming the connection conductive part 52 and the terminal conductive part 53 are opened is formed, and thereafter, the conductor layer 107 is formed (accumulated) and the resist pattern is removed.

Note that the connection conductive part 52 may be provided to connect the sensitive elements 31 without providing the connection part 32 as shown in FIGS. 8A and 8B, or may be provided to be placed on the connection part 32 constituted by the soft magnetic material layer 105. This holds true for the terminal conductive part 53, too.

In addition, in the case where the terminal conductive part 53, in particular, the pad part thereof is desired to be thicker than the connection conductive part 52, the connection conductive part 52 and the terminal conductive part 53 or the pad part of the terminal conductive part 53 may be formed in separate processes. The other processes may be the same as those in the magnetic sensor 1. In other words, magnetization of the thin film magnet 20 in the magnetic sensor 3 can be performed by applying the magnetizing device 400 described in the first exemplary embodiment.

Though illustration is omitted, in the magnetic sensor 2 shown in FIGS. 7A and 7B, the connection conductive part 52 and the terminal conductive part 53 may be used in place of the connection part 32 and the terminal part 33, or may be used to be placed on the connection part 32 and the terminal part 33, respectively.

### [Fourth exemplary embodiment]

In the magnetic sensor 1 to which the first exemplary embodiment was applied (refer to FIGS. 1A and 1B, the yokes 40a and 40b were brought into contact with the magnetic poles of the thin film magnet 20, to thereby cause the lines of magnetic force from the thin film magnet 20 to pass through the sensitive elements 31. In this case, the thin film magnet 20 supplies a bias magnetic field to the sensitive elements 31.

In a magnetic sensor 4 to which the fourth exemplary embodiment is applied, the magnetic poles of the thin film magnet 20 are magnetically exposed. Here, to magnetically expose means that a magnetic pole of the thin film magnet 20 is not covered with a magnetic material that terminates the lines of magnetic force from the other magnetic pole (the yoke). That is to say, the side surface serving as the magnetic pole of the hard magnetic material layer 103 constituting the thin film magnet 20 is exposed. This is sometimes expressed as a magnetic pole being opened. Note that the side surface of the hard magnetic material layer 103 just has to be magnetically exposed; the side surface may be covered with a nonmagnetic material for protecting the thin film magnet 20 against contamination, corrosion or the like.

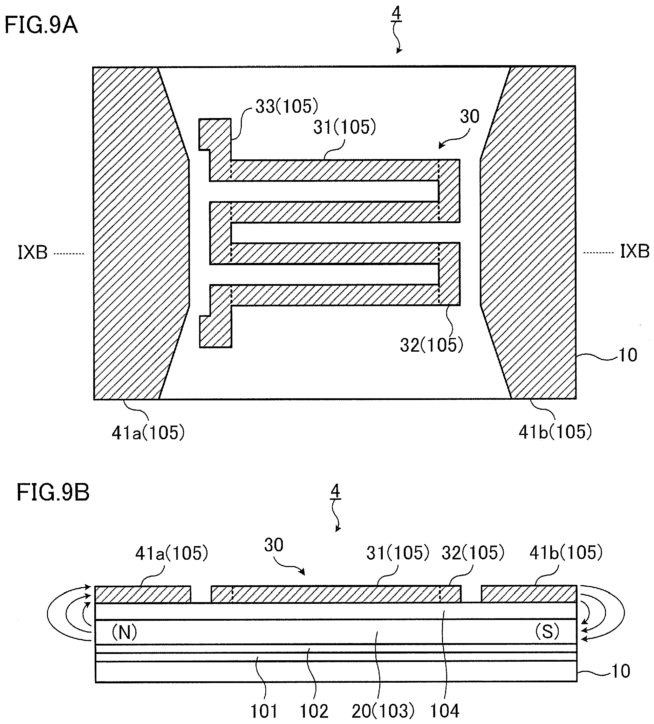

FIGS. 9A and 9B show diagrams illustrating an example of the magnetic sensor 4 to which the fourth exemplary embodiment is applied. FIG. 9A is a plan view and FIG. 9B is a cross-sectional view along the IXB-IXB line in FIG. 9A. Hereinafter, portions different from those of the magnetic sensor 1 will be mainly described, and similar portions will be assigned with same reference signs to thereby omit descriptions thereof.

As shown in FIG. 9B, the magnetic sensor 4, on the both magnetic pole sides of the thin film magnet 20 (on the right and left sides in FIG. 9B), end surfaces of the adhesive layer 101, the control layer 102, the hard magnetic material layer 103 and the insulating layer 104 are exposed. Then, yokes 41a and 41b (when they are not distinguished, referred to as yokes 41) are provided on the insulating layer 104. Note that the yokes 41 are constituted by the soft magnetic material layer 105, which is the same as the sensitive part 30.

The lines of magnetic force from the north pole of the thin film magnet 20 once go to the outside of the magnetic sensor 4. A part of the lines of magnetic force passes through the sensitive elements 31 of the sensitive part 30 and goes out of the magnetic sensor 4 again. Then, the lines of magnetic force that have passed through the sensitive element 31 of the sensitive part 30 and the lines of magnetic force that have not passed through the sensitive element 31 gather and return to the south pole. At this time, the lines of magnetic force from the thin film magnet 20 are affected by the outside (the state outside of the magnetic sensor 4). In other words, the lines of magnetic force passing through the sensitive elements 31 (the magnetic field applied to the sensitive elements 31) are varied by external changes. Consequently, the external changes can be measured by the sensitive elements 31.

The magnetic sensor 4 can be manufactured by eliminating, in the manufacturing method shown in FIGS. 2A to 2H, the process of forming the resist pattern 111 in FIG. 2A and the lift-off process of removing the resist pattern 111 in FIG. 2C. The other processes may be the same as those in the magnetic sensor 1. In other words, magnetization of the thin film magnet 20 in the magnetic sensor 4 can be performed by applying the magnetizing device 400 described in the first exemplary embodiment.

Note that, in the magnetic sensor 4, instead of the soft magnetic material layer 105, the magnetic material layer 106 described in the magnetic sensor 2 (the lower soft magnetic material layer 106a, the demagnetizing field suppressing layer 106b and the upper soft magnetic material layer 106c) may be used. Moreover, in the magnetic sensor 4, the connection conductive part 52 and the terminal conductive part 53 described in the magnetic sensor 3 may be used in place of the connection part 32 and the terminal part 33, or may be used to be placed on the connection part 32 and the terminal part 33, respectively.

### [Fifth exemplary embodiment]

In the magnetic sensor 4 to which the fourth exemplary embodiment was applied, as well as the north pole of the thin film magnet 20, the south pole was also in the state of being magnetically exposed. Consequently, the lines of magnetic force coming out of the north pole are divided into those once going out, then passing through the sensitive elements 31 of the sensitive part 30 and returning to the south pole and those returning to the south pole without passing through the sensitive elements 31. The fewer the lines of magnetic force passing through the sensitive elements 31, the smaller the magnetic field in the sensitive elements 31, and the smaller the impedance.

Therefore, in a magnetic sensor 5 to which the fifth exemplary embodiment is applied, one of the magnetic poles of the thin film magnet 20 (here, the north pole) is configured to be magnetically exposed.

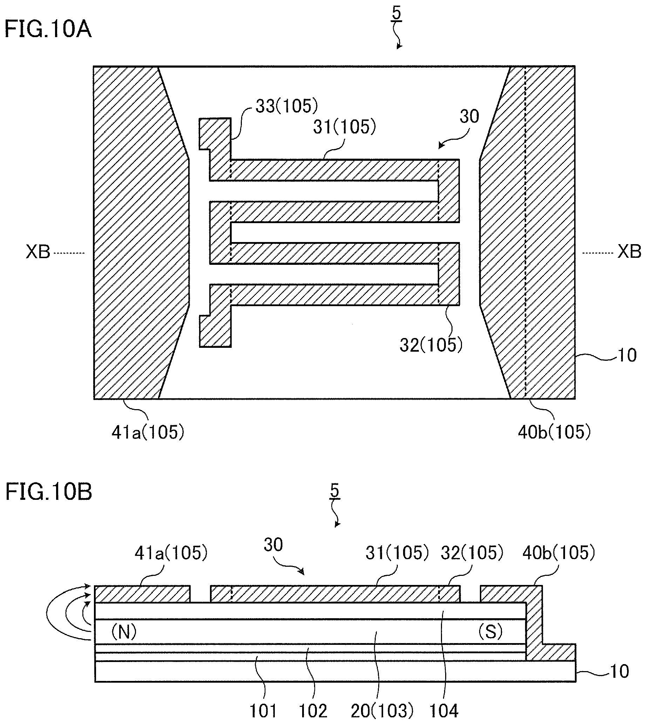

FIGS. 10A and 10B show diagrams illustrating an example of the magnetic sensor 5 to which the fifth exemplary embodiment is applied. FIG. 10A is a plan view and FIG. 10B is a cross-sectional view along the XB-XB line in FIG. 10A. Hereinafter, portions different from those of the magnetic sensor 1 will be mainly described, and similar portions will be assigned with same reference signs to thereby omit descriptions thereof.

Here, on the north pole side of the thin film magnet 20, similar to the magnetic sensor 4, the yoke 41a is provided on the insulating layer 104, whereas on the south pole side, similar to the magnetic sensor 1, the yoke 40b is provided. With this, the north pole is magnetically exposed, whereas the south pole is not magnetically exposed.

The magnetic sensor 5 can be manufactured by not providing the resist pattern 111 on the left side (the side serving as the north pole) in FIG. 2A in the method of manufacturing the magnetic sensor 1 shown in FIGS. 2A to 2H. The other processes may be the same as those in the magnetic sensor 1. In other words, magnetization of the thin film magnet 20 in the magnetic sensor 5 can be performed by applying the magnetizing device 400 described in the first exemplary embodiment.

Note that, in the magnetic sensor 5, instead of the soft magnetic material layer 105, the magnetic material layer 106 described in the magnetic sensor 2 (the lower soft magnetic material layer 106a, the demagnetizing field suppressing layer 106b and the upper soft magnetic material layer 106c) may be used. Moreover, in the magnetic sensor 4, the connection conductive part 52 and the terminal conductive part 53 described in the magnetic sensor 3 may be used in place of the connection part 32 and the terminal part 33, or may be used to be placed on the connection part 32 and the terminal part 33, respectively.

So far, the first to fifth exemplary embodiments have been described; however, various combinations and modifications may be available without deviating from the gist of the present invention.

### Reference Signs List

- 1-5: Magnetic sensor
- 10: Substrate
- 20: Thin film magnet
- 30: Sensitive part
- 31: Sensitive element
- 32: Connection part
- 33: Terminal part
- 40, 40a, 40b, 41, 41a, 41b: Yoke
- 52: Connection conductive part
- 53: Terminal conductive part
- 101: Adhesive layer
- 102: Control layer
- 103: Hard magnetic material layer
- 104: Insulating layer
- 105: Soft magnetic material layer
- 106: Magnetic material layer
- 106a: Lower soft magnetic material layer
- 106b: Demagnetizing field suppressing layer
- 106c: Upper soft magnetic material layer
- 107: Conductor layer
- 111, 112: Resist pattern
- 300: Magnetron sputtering device
- 310: Partition wall
- 320: Magnetron cathode
- 321: Cathode housing
- 322: Target
- 323: Backing plate
- 330: Magnetic circuit
- 331, 332: Magnet
- 333: Yoke
- 340: Chamber
- 350: Substrate holder
- 360: High-frequency power supply
- 400: Magnetizing device
- 410: Stage
- 420: Magnetizing head
- 422: Yoke
- 423: Yoke
- 430: holder part

## Claims

1. A method of manufacturing a magnetic sensor, comprising:
a hard magnetic material layer formation process forming a hard magnetic material layer to be processed into a thin film magnet on a disk-shaped nonmagnetic substrate;
a soft magnetic material layer formation process forming a soft magnetic material layer laminated on the hard magnetic material layer on the substrate, the soft magnetic material layer being processed into a sensitive element sensing a magnetic field; and
a hard magnetic material layer magnetization process magnetizing the hard magnetic material layer in a circumferential direction of the disk-shaped substrate.

2. The method of manufacturing a magnetic sensor according to claim 1, wherein the hard magnetic material layer magnetization process performs the magnetization by rotating the substrate around a center thereof while moving a magnetizing member in a radial direction, the magnetizing member generating a magnetic field in a direction along the circumferential direction of the substrate, the magnetic field being equal to or larger than a coercive force of the hard magnetic material layer.

3. The method of manufacturing a magnetic sensor according to claim 2, wherein the magnetizing member is provided with a north pole and a south pole disposed in the circumferential direction, held in a state of being separated from the substrate with a predetermined distance, and provides the magnetic field to the hard magnetic material layer, the magnetic field being larger than the coercive force of the hard magnetic material layer.

4. The method of manufacturing a magnetic sensor according to any one of claims 1 to 3, wherein the soft magnetic material layer formation process forms the soft magnetic material layer by magnetron sputtering and provides uniaxial magnetic anisotropy in a direction intersecting the circumferential direction of the substrate by a magnetic field used in the magnetron sputtering.

5. The method of manufacturing a magnetic sensor according to claim 4, wherein the magnetron sputtering in the soft magnetic material layer formation process is performed in a plane facing a surface of the substrate by use of a cathode in which magnets having an asymmetrical structure with respect to the center of the substrate rotate.

6. The method of manufacturing a magnetic sensor according to claim 1 or 2, further comprising:
a control layer formation process forming a control layer between the substrate and the hard magnetic material layer, the control layer controlling magnetic anisotropy of the hard magnetic material layer in an in-plane direction.

7. A magnetic sensor assembly comprising:
a plurality of magnetic sensors, each of which comprises:
a thin film magnet constituted by a hard magnetic material layer and magnetized in an in-plane direction; and
a sensitive element constituted by a soft magnetic material layer laminated on the hard magnetic material layer, the sensitive element sensing a magnetic field, wherein
the thin film magnet in each of the plurality of magnetic sensors is magnetized in a circumferential direction of a disk-shaped substrate on which the plurality of magnetic sensors is formed.

8. The magnetic sensor assembly according to claim 7, wherein the sensitive element includes a longitudinal direction and a short direction, the short direction being provided in a direction intersecting a direction in which the thin film magnet is magnetized.

9. The magnetic sensor assembly according to claim 7 or 8, wherein the sensitive element is constituted by a plurality of soft magnetic material layers, the soft magnetic material layers being antiferromagnetically-coupled with a demagnetizing field suppressing layer composed of Ru or an Ru alloy interposed therebetween.
